# EUROPEAN PATENT SPECIFICATION

(11) **EP 3 196 694 B1**
(45) Date of publication and mention of the grant of the patent: **27.11.2019**
(21) Application number: 16151885.7
(22) Date of filing: 19.01.2016
(51) Int. Cl.: H03M 1/12, G02F 7/00, G02F 1/35, G02F 1/225

(54) **OPTICALLY SAMPLED ANALOG-TO-DIGITAL CONVERTER AND METHOD FOR USING THE ANALOG-TO-DIGITAL CONVERTER**
OPTISCH ABGETASTETER ANALOG-DIGITAL-WANDLER UND VERFAHREN ZUR VERWENDUNG DES ANALOG-DIGITAL-WANDLERS
CONVERTISSEUR ANALOGIQUE-NUMÉRIQUE OPTIQUEMENT ÉCHANTILLONNÉ ET PROCÉDÉ D'UTILISATION DUDIT CONVERTISSEUR

(43) Date of publication of application: 26.07.2017
(73) Proprietor: Technische Universität Dresden, 01069 Dresden (DE)
(72) Inventor: Jamshidi, Kambiz, 01187 Dresden (DE); Khafaji, Mohammad Mahdi, 01069 Dresden (DE); Ellinger, Frank, 01069 Dresden (DE)
(74) Representative: Lippert Stachow Patentanwälte Rechtsanwälte Partnerschaft mbB

(56) References cited:
- ANATOL KHILO ET AL: "Photonic ADC: overcoming the bottleneck of electronic jitter", OPTICS EXPRESS, vol. 20, no. 4, 13 February 2012 (2012-02-13), page 4454, XP055282849, ISSN: 2161-2072, DOI: 10.1364/OE.20.004454
- PFEIFLE J ET AL: "Microresonator-based frequency comb generator as optical source for coherent WDM transmission", OPTICAL FIBER COMMUNICATION CONFERENCE AND EXPOSITION AND THE NATIONAL FIBER OPTIC ENGINEERS CONFERENCE (OFC/NFOEC), 2013, IEEE, 17 March 2013 (2013-03-17), pages 1-3, XP032679185, ISBN: 978-1-4799-0457-0 [retrieved on 2013-06-14]
- VICTOR TORRES-COMPANY ET AL: "Optical frequency comb technology for ultra-broadband radio-frequency photonics", LASER & PHOTONICS REVIEWS, vol. 8, no. 3, 18 May 2014 (2014-05-18), pages 368-393, XP055283292, DE ISSN: 1863-8880, DOI: 10.1002/lpor.201300126

## Description

The present invention provides Analog-to-Digital Converter comprising an optical source providing radiation of one single wavelength, an electro-optic modulator sampling an analogue signal provided at an electrical input, a demultiplexer which de-multiplex the optically sampled signal, at least one photodetector converting the sampled signal into an electrical signal, transimpedance amplifiers amplifying the signals and at least one analogue-to-digital converter converting the analogue signal into a digital signal.

The present invention also provides a method of converting an analogue signal to a digital signal.

### Field of the invention

Analog to digital converters (ADC) are key components to convert real world continuously varying analog signals to digital data for use by digital systems that process, store, interpret, and manipulate digital data. Analogue signals will be detected, transmitted and received for example by sensors or in telecommunication by antennas. For further signal processing these signals often need to be converted into digital domain in order to be used in computers or microprocessors, etc. Generally, this conversion is necessary whenever mapping from analog signals to digital data is needed. For example, a leading company in this area had annual global revenue of more than 1 Billion Dollars in 2010 for both ADCs and Digital to Analog converters (DAC). Various ADCs already exist in electronic industry having different resolutions, sampling rates, and bandwidths.

### Background of the invention

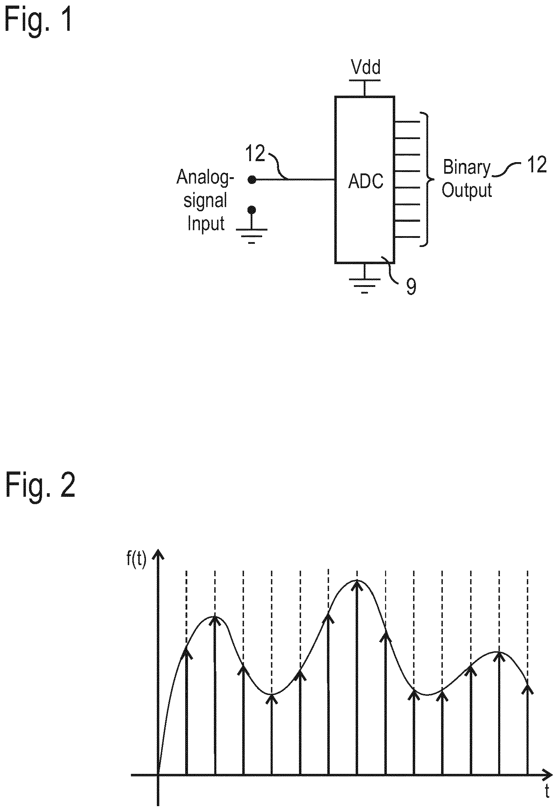

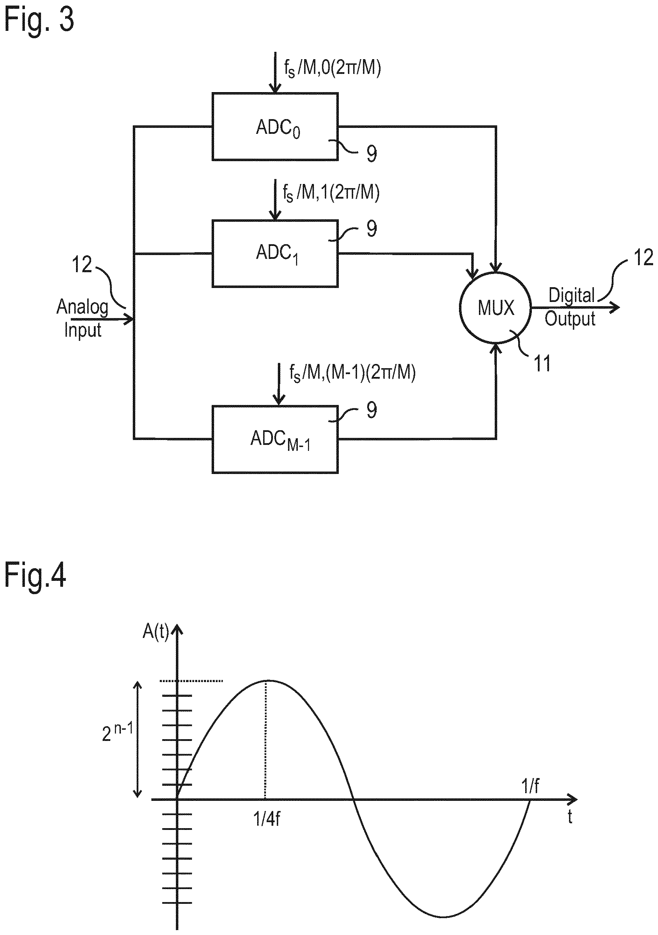

The fast growth of data rates in recent communication systems has created vast demand for multi-GSps (Giga samples per second) data converters. Some applications, such as radar signal processing, communications, and instrumentation, require analog-to-digital conversion at rates exceeding that of electronic ADCs. For these applications, electro optic devices can be used to perform the analog-to-digital conversion. Current spectrally-efficient optical links as well as over 100 Gbps wireless communications are not the only areas which benefit from such data converters. An ADC in millimeter-wave range frequencies plays an important role in advancing measurement systems, medical imaging, and radar systems as well. The majority of current designs rely on successive approximation register (SAR) and time-interleaving (TI) techniques to implement the ADC. The time-interleaving technique is based on parallel functioning of M slower ADC cores, whereas M is the number of ADCs in the system. The system cycles through a set of M sub-ADCs, such that the aggregate throughput is M times the sample rate of the individual sub-ADCs. Figure 1 shows a conventional single channel ADC that converts an analogue signal that is continuous in time into a digital binary output stream. The sampling is the reduction of a continuous signal to a discrete signal meaning into a flow of digital values, whereas the sampling rate corresponds to the throughput rate. Figure 2 shows the signal sampling. The continuous signal is represented with a continuous line while the discrete samples are indicated by the vertical arrow lines. Therefore, such a system of parallel functioning or a system with such architecture enables the sample rate to be pushed further than that achievable with single channel ADCs. Because of each core does not need to work at the full Nyquist rate of the input signal. Thereby the requirements of the quantization stage can be simplified. On the other hand, for the output to be a digital representation of the input signal, the Nyquist criterion has to be fulfilled. It means that with M-times slower ADCs, there is a need for M sampling points in one period of the highest input frequency. This is achieved by spacing the sampling instances by 2π/M phase differences. This is shown in a conceptual schematic of a TI-ADC in Fig. 3. Several ADCs at a lower speed are converting the analog input signal to a digital word. The challenge in this architecture is towards the sampling stage tight time alignment and Nyquist bandwidth.

The consequence is that, the challenge in a TI-ADC is shifted towards implementing an accurate sampling stage. First, it should fulfill the bandwidth requirements of the system. Second, the difference among sampling phases has to be maintained. These are key factors in the final TI-ADC performance. For example, an ADC at a functioning rate of 50 GSps has to sample the analog input signal with a maximum bandwidth of 25 GHz at every 20 ps. By four times interleaving, the sampling clock signal frequency is decreased to 12.5 GHz, and the operation time of each ADC core is then increased to 80 ps. The delay between sampling signals is 20 ps, and so there should be a circuit which can generate and maintain this time precisely. A deviation in the sampling time causes an error at the output, which is called aperture error. One source causing this aperture error, independent from the utilized circuit, is jitter. Jitter is a proportional error of the temporal change of the input signal. Figure 4 shows in a basic scheme how sampling resolution is limited by jitter. It is due to the use of a non-ideal sampling clock that results in some uncertainty when samples are recorded. It has been shown that achieving a specific signal-to-noise ratio (SNR) at higher frequencies necessitates lower jitter.

The key to advance current state-of-the-art ADC designs is to realize a sampling stage with higher input bandwidth and at the same time lower jitter. The increased operational bandwidth brings many advantages to applications across many market segments. Radio systems can increase the number of supported bands; radar systems can improve spatial resolution, and measurement equipment can achieve greater analog input bandwidth. It has been shown that in the last decade, the sampling jitter in electrical ADCs could not reach values considerably lower than 80 fs. Optical oscillators can potentially have much less jitter than their electronic counterparts. For example jitter of mode locked lasers (MLL) can be even less than 0.1 fs. This low jitter of MLLs, makes them an attractive candidate compared to electrical oscillators to provide clock for sampling the electrical signals. Potentially, this would provide a benefit of one order of magnitude in the sampling jitter, which in turn makes it possible to raise the SNR up to 20dB. In addition, the sampling rate of an optical sampling circuit can also be higher than that of the electrical one.

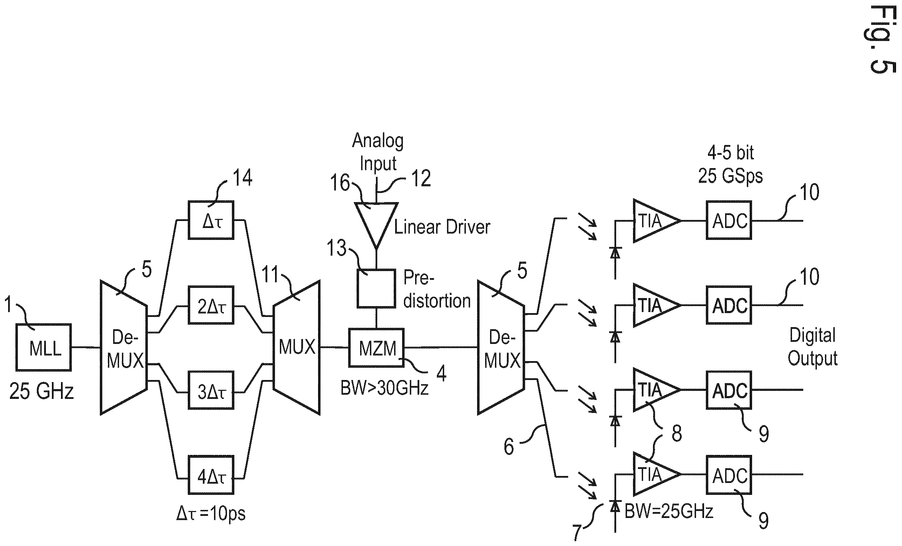

Fig. 5 shows an electrical ADC combined with a low-jitter optical sampling stage according to the state of the art. In addition to the mode locked lasers, an electro-optical (E/0) modulator is employed to provide the optical samples of the electrical input. A mode locked laser provides the optical source and emits ultrashort pulses on the basis of the technique of mode locking. A de-multiplexer switches the ultrashort pulses to one of several outputs. The signals of the several outputs are shifted in time in order to separate them from each other by Δτ. Afterwards these modified signals are multiplexed and routed to a Mach Zehnder modulator by a multiplexer. The Mach Zehnder modulator is used for sampling the analogue signal that is provided at the electrical input of this electro optical modulator. The optical sampled analogue output signal at the electro optical modulator is switched to several different outputs by a second de-multiplexer. These optical output signals are converted by photodetectors into the electrical domain. Subsequently the analogue signals of the different outputs are converted to the digital domain by ADCs.

In US 6,118,396 an ultra-fast electro optic analog-to-digital converter is described. The ADC includes an electro optic modulator that generates a modulated light beam from a high speed laser beam in response to an applied modulation signal. An optical de-multiplexer is positioned to receive the modulated laser beam and couple them to different photodetectors. Each of the photodetectors generates an electrical signal in response to an intensity of the demultiplexed modulated laser beam. ADCs convert the signals to a digital representation of the incident laser beam.

The inherent advantages of electro optic ADCs mentioned above, also have encouraged several groups to implement photonic ADCs so far like in US7940201B1, A. Khilo, et al., "Photonic ADC; overcoming the bottleneck of electronic jitter", Opt. Express, vol. 20, no. 4, pp.4454-4469, Feb.2012, US7956788B2, US8334797 B1, US8548331 B1, US8446305 B1. Employing optical sampling with electrical quantization in an ADC design would allow advancing the sampling rate and massively increasing the analog input bandwidth compared to fully electrical ADCs. Using discrete optical components it was even possible to sample electrical signals with a rate of more than 100 GSps. The main issue for these methods is that they usually use expensive and energy consuming bulky devices.

Therefore, it is the predominant task to simplify the production and to reduce the cost in order to fabricate these important devices in high volumes much easier. The main problem in realizing the photonic part of a photonic ADC and using conventional electronics afterwards is that nonlinearities in the photonic parts cannot be properly compensated and therefore the advantages of using photonic devices cannot be fully exploited in the prior art.

It is therefore also an object of the invention to overcome the problems in compensating the nonlinearities in the photonic parts and to simplify and reduce the overall cost for optically sampled ADCs.

Another main objective of the invention is to realize a monolithic high sampling rate ADC using optical sampling based on electronic-photonic integrated circuits with a low jitter.

The object of the invention will be achieved thereby that a multi wavelength generator and a chromatic dispersion element are provided generating several wavelengths and delays of the single wavelength radiation of the optical source and that except to the optical source all electrical and photonic components are integrated on one chip.

The advantage of using electronic photonic integrated components is that the devices will be more efficient in operation, as the integration and miniaturization of circuit structures on one chip or platform allows an increase in switching speeds, through shorter cable lengths, thus achieving shorter signal transit times and lower latencies in the components, and reducing the power consumption of the integrated circuits. Furthermore, the combination and integration of electrical and optical components on one chip allows co-optimizing both the electrical and optical components at the same time.

Moreover, it is beneficial to use integrated devices, which can be easier fabricated in high volumes.

The optical source emits a continuous wave. A multi wavelength generator and a chromatic dispersion element that are connected in series provide optical signal components with different wavelengths and specific delays to each other. An electro optical modulator receives the optical signal components at a signal input and receives the analogue electrical modulation signal at a modulation input. The electro optical modulator modulates the optical signal with the analogue electrical signal. The output of the modulator varies periodically as a function of the electrical signal applied to the modulation input.

In a preferred embodiment of the invention a pre-distortion stage is provided at the electrical input of the analogue signal.

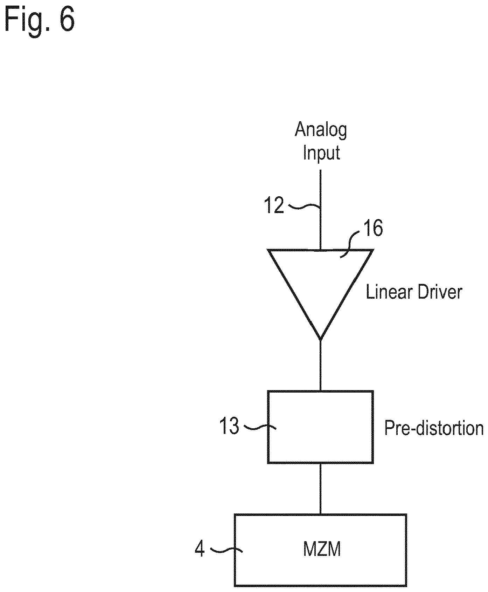

Nonlinearities of the modulators can be compensated by pre-distortion of the signal in modulator drivers. If an integrated Mach zehnder modulator is implemented by diodes, then the exhibited nonlinearity can possibly be compensated by a pre-distortion stage at the electrical input. This is illustrated in figure 6. Considering this embodiment it is possible to increase the resolution of the ADC without affecting its bandwidth.

In another preferred embodiment the optical source is a single continuous wave laser. A continuous wave laser is a laser that emits a light wave of constant intensity, as opposed to pulsed lasers. Laser radiation from continuous wave lasers is ideally narrow-band (monochrome, color), meaning, it only consists of radiation of one wavelength. In particular, continuous wave laser radiation generated by stable laser resonators is coherent due to multiple cycles, either temporally or longitudinally (along with the propagation direction), which means that the emitted waves swing not only with the same frequency, but are also constant in the phase over a long distance (the coherence length). The advantage of a continuous wave laser is its simple configuration in contrast to mode locked lasers. The continuous wave laser has a fixed frequency input, and the need for more complex implementation of mode lock lasers will be relaxed. The mode lock lasers have a very complex configuration because of the exact input pulses which are needed for the subsequent processes and they are therefore very expensive.

In a preferred embodiment of the invention the multi wavelength generator is a ring resonator, meaning the multi wavelength generator is a combination of nonlinearity and dispersion formed in ring structure. Several wavelengths can be generated by interpolation between dispersion and nonlinearity in the ring. By using a chromatic dispersion element the various wavelengths will shift in time and different delays will be introduced to different wavelengths. Therefore only one single multiplexer and demultiplexer is needed in contrast to previous solutions.

The object of the invention will be solved also by a method using the novel and inventive claimed Analog-to-Digital Converter wherein the method comprising the following steps: A single wavelength is provided by an optical source, wherein optical signals with different wavelengths will be generated by a multi wavelength generator out of the single wavelength of the optical source. The different wavelengths are shifted in time and delayed by using a chromatic dispersion element. In a next step an electrical analogue signal that is inputted to the system is sampled by an electro optical modulator using the different generated optical signals. The different optical signals are mapped to different waveguides by a de-multiplexer and then the optical signals are converted to electrical signals by photodetectors. Moreover the optically-sampled signals are amplified by transimpedance amplifiers and last but not least the analogue signal is converted to a digital signal by an analog-to-digital converter.

In a very preferred embodiment of the method the electrical analogue signal is pre-distorted by a pre-distortion stage at the analogue electrical input of the system. Assuming that the mach-zehnder modulator that can be used for the electro optical conversion is integrated on a silicon substrate it has characteristics similar to a diode. Therefore, the nonlinearities of the electro optical modulator can be compensated by pre-distortion stage.

The invention and examples will be illustrated by means of embodiments.

The corresponding drawings show
Fig. 1 A conceptual schematic of a conventional single channel ADC;
Fig. 2 The sampling representation of a continuous signal;
Fig. 3 A conceptual schematic of a TI-ADC;
Fig. 4 Schematics of the relation between quantization accuracy and jitter;
Fig. 5 The basic idea of optically sampled ADC according to an example using a mode looked laser according to the state of the art;
Fig. 6 An illustration of a pre-distortion stage before the mach zehnder modulator, which can potentially compensate a portion of electro optical modulator nonlinearity;
Fig. 7 An optically sampled ADC according to the invention using just a single line laser whereas all components are integrated on one chip, except the laser source;

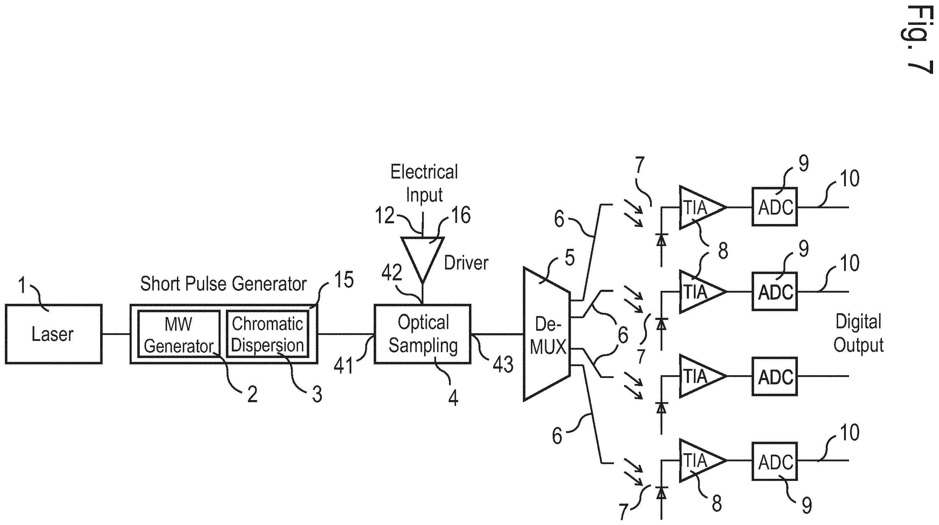

Fig. 7 shows a schematic drawing of a fully integrated photonic ADC according to the invention that can be the solution of the previous problems thereby the all electronic and photonic parts are integrated together in the same platform using electronic photonic integrated circuits. This is necessary to co-optimize both the electrical and optical components at the same time which is the basis in the next generation ADCs in higher than 100 GSps arena.

In fig. 7 the optical source 1 emits a continuous wave. A short pulse generator 15 is used to generate the short pulse needed for sampling. This short pulse generator consists of a multi wavelength generator 2 and a chromatic dispersion element 3 that are connected in series and provide optical signal components with different wavelengths and specific delays to each other. An electro optical modulator 4 receives the optical signal components at a signal input 41 and receives the analogue electrical modulation signal at a modulation input 42. The electro optical modulator 4 modulates the optical signal with the analogue electrical signal. The output of the modulator 43 varies periodically as a function of the electrical signal applied to the modulation input 41.

In a TI-ADC with M cores, the final sampling rate of the system is M times higher than that of each ADC. The time interleaving behavior in the current approach is obtained by increasing the number of branches of the optical multiplexer (MUX) and de-multiplexer (De-MUX). For example, if the optical de-multiplexer (DE-MUX) 5 is designed by e.g. 4 output branches 6, then all the components of each branch have to work at a speed of 25 GHz to achieve targeted rate of 100 GSps. If the speed is maintained, then adding one extra branch results in 5 ADCs each operates at 20 GHz speed. While the mach zehnder modulator 4 needs a bandwidth as large as the input signal 12, other components in each branch, do not need a bandwidth higher than the sampling rate. This is one main concept of TI-ADCs and a reason for popularity of this architecture. Another point to mention is that Nyquist criterion shows the minimum required sampling rate to reconstruct the signal. When a signal is sampled at higher rate than this frequency, the aliasing takes place at higher frequencies and it is easier to filter them out. Therefore, there are benefits even if it may not be possible to have a bandwidth as high as the Nyquist rate.

The schematic drawing in figure 7 also presents a possible scenario of 100 GSps ADC. In this method in contrast to previous methods, which use mode locked laser or multiple laser sources as shown in figure 5, just a single continuous wave laser is being used as the source 1. By using a multi wavelength generator 2, preferably a ring resonator which is designed for this purpose, several wavelengths will be generated and by using a chromatic dispersion element 3, various wavelengths will shift in time and different delays will be introduced to different wavelengths. After sampling by using an electro optical modulator 4, a de-multiplexer 5 will map different wavelengths to different waveguides 6, and eventually multiple photodetectors 7 will be used to convert the optical signals to electrical signals. After detection of optically-sampled signal, a transimpedance amplifier (TIA) 8 will amplify the signal and finally it will provide the input for comparators at the input of the electrical ADC 9.

The major advantages of the presented invention can be summarized as follows:
Firstly, a single wavelength laser is utilized instead of having multiple wavelength sources like mode locked lasers. This is less expensive and reduces costs.

Secondly, with the monolithic realization of optically sampled ADC, lower parasitics exist in sampling and receiver circuit and therefore less jitter can be achieved.

Thirdly, with the optimized analogue to digital conversion system less space is required on the chip since just one multiplexer or de-multiplexer is required for the realization.

Fourthly, the monolithic realization of optically sampled analog to digital converter has the ability to be fabricated in large scales much easier than its discrete optoelectronic counterparts which have been produced before.

Fifthly, nonlinearities of optoelectronic devices (like optical modulators and photodiodes) can be compensated using electronic devices, like drivers and transimpedance amplifiers that can be easily integrated on the chip and can be adapted to the particular application or the other components that are used.

Sixthly, in comparison to electronic ADCs, higher sampling rates can be achieved using optical signal for sampling the electronic signals.

### Reference numerical list

- 1: optical source
- 2: multi wave generator
- 3: chromatic dispersion element
- 4: electro optical modulator
- 41: optical signal input of the modulator
- 42: electrical signal input of the modulator
- 43: output of the modulator
- 5: de-multiplexer
- 6: optical waveguides, branches
- 7: photodetector
- 8: transimpedance amplifier
- 9: analogue-to-digital converter
- 10: digital output
- 11: multiplexer
- 12: analogue input
- 13: pre-distortion stage
- 14: time delay
- 15: short pulse generator

## Claims

1. Optically sampled Analog-to-Digital Converter comprising
- an optical source (1) providing radiation of one single wavelength;
- an electro-optic modulator (4) sampling an analogue signal provided at an electrical input;
- a de-multiplexer (5) de-multiplexing the optically sampled signal;
- photodetectors (7) converting the optically sampled signal into electrical signals;
- transimpedance amplifiers (8) amplifying the electrical signals and
- electrical analogue-to-digital converters (9) converting the amplified signals into digital signals; whereby except to the optical source (1) all electrical and photonic components are integrated on one chip,
**characterized by** additionally comprising a multi wavelength generator (2) as a ring resonator generating several wavelengths of the single wavelength radiation of the optical source (1) and a chromatic dispersion element (3) shifting the generated several wavelengths in time and introducing different delays to each of the several wavelengths.

2. Optically sampled Analog-to-Digital Converter according to claim 1, **characterized in that** a pre-distortion stage (13) is provided at the electrical input (12) of the analogue signal.

3. Optically sampled Analog-to-Digital Converter according to claim 1, **characterized in that** the optical source (1) is a single continuous wave laser.

4. Optically sampled Analog-to-Digital Converter according to claim 1, **characterized in that** the multi wavelength generator (2) is a combination of nonlinearity and dispersion in ring structure.

5. A method of converting an analogue signal to a digital signal using the optically sampled Analog-to-Digital converter according to claims 1 to 4, **wherein** the method comprising:
- providing a single wavelength by an optical source (1) ;
- generating optical signals with different wavelengths by a multi wavelength generator (2) out of the single wavelength of the optical source;
- shifting in time and delaying the different wavelengths by using a chromatic dispersion element (3) ;
- sampling an electrical analogue signal by an electro optical modulator (4) using the differently generated optical signals;
- mapping the different optical signals to different waveguides (6) by a de-multiplexer (5);
- converting the optical signals to electrical signals by photodetectors (7);
- amplifying the resulting electrical signals by transimpedance amplifiers;
- converting the amplified signals to digital signals by analog-to-digital converters (9).

6. The method according to claim 5, **characterized in that** the electrical analogue signal is pre-distorted by a pre-distortion stage (13).

7. The method according to claims 6, **characterized in that** the pre-distortion stage (13) compensates nonlinearities of the electro optical modulator (4).

## Patentansprüche

1. Optisch abgetasteter Analog-Digital-Wandler, umfassend:
- eine optische Quelle (1), welche Strahlung einer einzigen Wellenlänge bereitstellt;
- einen elektrooptischen Modulator (4), der ein analoges Signal abtastet, das an einem elektrischen Eingang bereitgestellt wird;
- einen Demultiplexer (5), der das optisch abgetastete Signal demultiplext;
- Photodetektoren (7), die das optisch abgetastete Signal in elektrische Signale umwandeln;
- Transimpedanzverstärker (8), welche die elektrischen Signale verstärken;
und
- elektrische Analog-Digital-Wandler (9), welche die verstärkten Signale in digitale Signale umwandeln; wobei mit Ausnahme der optischen Quelle (1) alle elektrischen und photonischen Komponenten auf einem Chip integriert sind,
**dadurch gekennzeichnet, dass** er zusätzlich umfasst:
einen Mehrfachwellenlängengenerator (2) als einen Ringresonator, der mehrere Wellenlängen aus der Strahlung mit der einzigen Wellenlänge der optischen Quelle (1) erzeugt, und ein chromatisches Dispersionselement (3), das die erzeugten mehreren Wellenlängen zeitlich verschiebt und verschiedene Verzögerungen in jede der mehreren Wellenlängen einführt.

2. Optisch abgetasteter Analog-Digital-Wandler nach Anspruch 1, **dadurch gekennzeichnet, dass** eine Vorverzerrungsstufe (13) am elektrischen Eingang (12) des analogen Signals vorgesehen ist.

3. Optisch abgetasteter Analog-Digital-Wandler nach Anspruch 1, **dadurch gekennzeichnet, dass** die optische Quelle ein einziger Dauerstrichlaser ist.

4. Optisch abgetasteter Analog-Digital-Wandler nach Anspruch 1, **dadurch gekennzeichnet, dass** der Mehrfachwellenlängengenerator (2) eine Kombination aus Nichtlinearität und Dispersion in Ringstruktur ist.

5. Verfahren zur Umwandlung eines analogen Signals in ein digitales Signal unter Verwendung des optisch abgetasteten Analog-Digital-Wandlers nach den Ansprüchen 1 bis 4, wobei das Verfahren umfasst:
- Bereitstellen einer einzigen Wellenlänge durch eine optische Quelle (1);
- Erzeugen von optischen Signalen mit verschiedenen Wellenlängen durch einen Mehrfachwellenlängengenerator (2) aus der einzigen Wellenlänge der optischen Quelle;
- zeitliches Verschieben und Verzögern der verschiedenen Wellenlängen durch Verwenden eines chromatischen Dispersionselements (3);
- Abtasten eines elektrischen analogen Signals durch einen elektrooptischen Modulator (4) unter Verwendung der unterschiedlich erzeugten optischen Signale;
- Zuordnen der verschiedenen optischen Signale zu verschiedenen Wellenleitern (6) durch einen Demultiplexer (5);
- Umwandeln der optischen Signale in elektrische Signale durch Photodetektoren (7);
- Verstärken der resultierenden elektrischen Signale durch Transimpedanzverstärker;
- Umwandeln der verstärkten Signale in digitale Signale durch Analog-Digital-Wandler (9).

6. Verfahren nach Anspruch 5, **dadurch gekennzeichnet, dass** das elektrische analoge Signal durch eine Vorverzerrungsstufe (13) vorverzerrt wird.

7. Verfahren nach Anspruch 6, **dadurch gekennzeichnet, dass** die Vorverzerrungsstufe (13) Nichtlinearitäten des elektrooptischen Modulators (4) kompensiert.

## Revendications

1. Convertisseur analogique/numérique à échantillonnage optique, comprenant
- une source optique (1) fournissant un rayonnement d'une seule longueur d'onde ;
- un modulateur électro-optique (4) échantillonnant un signal analogique fourni au niveau d'une entrée électrique ;
- un démultiplexeur (5) démultiplexant le signal échantillonné optiquement ;
- des photodétecteurs (7) convertissant le signal échantillonné optiquement en signaux électriques ;
- des amplificateurs de transimpédance (8) amplifiant les signaux électriques ; et
- des convertisseurs analogique/numérique électriques (9) convertissant les signaux amplifiés en signaux numériques ;
de sorte qu'excepté la source optique (1), tous les composants électriques et photoniques sont intégrés sur une seule puce,
**caractérisé en ce qu'**il comprend en outre
un générateur de longueurs d'onde multiples (2) sous la forme d'un résonateur en anneau générant plusieurs longueurs d'onde du rayonnement à longueur d'onde unique de la source optique (1) et un élément de dispersion chromatique (3) décalant les plusieurs longueurs d'onde générées dans le temps et introduisant différents retards dans chacune des plusieurs longueurs d'onde.

2. Convertisseur analogique/numérique à échantillonnage optique selon la revendication 1, **caractérisé en ce qu'**un étage de pré-distorsion (13) est prévu à l'entrée électrique (12) du signal analogique.

3. Convertisseur analogique/numérique à échantillonnage optique selon la revendication 1, **caractérisé en ce que** la source optique (1) est un seul laser à onde continue.

4. Convertisseur analogique/numérique à échantillonnage optique selon la revendication 1, **caractérisé en ce que** le générateur de longueurs d'onde multiples (2) est une combinaison de non linéarité et de dispersion dans une structure en anneau.

5. Procédé de conversion d'un signal analogique en un signal numérique en utilisant le convertisseur analogique/numérique à échantillonnage optique selon les revendications 1 à 4, le procédé comprenant les étapes consistant à :
- fournir une longueur d'onde unique par une source optique (1) ;
- générer des signaux optiques avec différentes longueurs d'onde par un générateur de longueurs d'onde multiples (2) à partir de la longueur d'onde unique de la source optique ;
- décaler dans le temps et retarder les différentes longueurs d'onde en utilisant un élément de dispersion chromatique (3) ;
- échantillonner un signal analogique électrique par un modulateur électro-optique (4) en utilisant les signaux optiques générés différemment ;
- mapper les différents signaux optiques sur différents guides d'ondes (6) par un démultiplexeur (5) ;
- convertir les signaux optiques en signaux électriques par des photodétecteurs (7) ;
- amplifier les signaux électriques résultant par des amplificateurs de transimpédance ;
- convertir les signaux amplifiés en signaux numériques par des convertisseurs analogique/numérique (9) .

6. Procédé selon la revendication 5, **caractérisé en ce que** le signal analogique électrique est pré-distordu par un étage de pré-distorsion (13).

7. Procédé selon la revendication 6, **caractérisé en ce que** l'étage de pré-distorsion (13) compense des non linéarités du modulateur électro-optique (4).
